(19) Europäisches Patentamt
European Patent Office
Office européen des brevets

(11) **EP 2 726 885 B1**

(12) **EUROPÄISCHE PATENTSCHRIFT**

(45) Veröffentlichungstag und Bekanntmachung des Hinweises auf die Patenterteilung:
**26.04.2017 Patentblatt 2017/17**

(51) Int Cl.:
***G01R 1/20*** *(2006.01)*    ***G01R 35/00*** *(2006.01)*

(21) Anmeldenummer: **12721294.2**

(22) Anmeldetag: **16.05.2012**

(86) Internationale Anmeldenummer:
**PCT/EP2012/059099**

(87) Internationale Veröffentlichungsnummer:
**WO 2013/000621 (03.01.2013 Gazette 2013/01)**

(54) **VERFAHREN UND SYSTEM ZUM KALIBRIEREN EINES SHUNT-WIDERSTANDS**

METHOD AND SYSTEM FOR CALIBRATING A SHUNT RESISTOR

PROCÉDÉ ET SYSTÈME D'ÉTALONNAGE D'UNE RÉSISTANCE DE SHUNT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.06.2011 DE 102011078334**

(43) Veröffentlichungstag der Anmeldung:
**07.05.2014 Patentblatt 2014/19**

(73) Patentinhaber: **Robert Bosch GmbH**
**70442 Stuttgart (DE)**

(72) Erfinder:
• **MUELLER, Bernd**
**72766 Reutlingen (DE)**
• **WIEJA, Thomas**
**72810 Gomaringen (DE)**

(56) Entgegenhaltungen:
**EP-A1- 0 265 076        EP-A1- 1 607 753**
**EP-A1- 2 169 412        DE-A1- 10 310 503**
**US-A1- 2003 020 592     US-B1- 6 489 881**
**US-B1- 7 023 217**

EP 2 726 885 B1

**Beschreibung**

Die Erfindung betrifft Verfahren und Systeme zum Kalibrieren eines Shunt-Widerstands, insbesondere eines metallischen Shunt-Widerstands.

Stand der Technik

Für Stromregelverfahren ist es notwendig, den zu regelnden Strom zu messen. Üblicherweise wird der Strom indirekt als Spannung über einen von dem zu messenden Strom durchflossenen Messwiderstand bzw. Shunt-Widerstand gemessen. Aus dem Verhältnis von gemessener Spannung und Widerstand des durchflossenen Shunt-Widerstands kann dann auf den Messstrom zurückgeschlossen werden. Die Präzision der Strommessung hängt dabei entscheidend von der präzisen Kenntnis über den Widerstandswert des Shunt-Widerstands ab.

Häufig werden Shunt-Widerstände verwendet, deren Widerstandstoleranz gering genug für den zu messenden Strom ist und deren Temperaturabhängigkeit im Idealfall Null ist oder zumindest einer bekannten Verteilung folgt. In letzterem Fall kann die an dem Shunt-Widerstand gemessene Spannung gemäß der bekannten Temperaturabhängigkeit korrigiert werden. Beispielsweise kann die gemessene Spannung mit einer Referenzspannung korrigiert werden, welche die gleiche bekannte Temperaturabhängigkeit aufweist wie der Shunt-Widerstand.

Die Bestimmung der Referenzspannung kann beispielsweise vor der ersten Inbetriebnahme des Shunt-Widerstands erfolgen und als Referenz in die Messapparatur vorkonfiguriert werden. Insbesondere metallische Shunt-Widerstände können jedoch ihren Widerstandswert im Laufe des Betriebs ändern, beispielsweise durch Materialalterung. Da diese Materialalterung unter anderem von dem vor Inbetriebnahme unbekannten Stromfluss durch den Shunt-Widerstand abhängen kann, kann eine einmalige Vorkonfiguration der Messapparatur mit einer Referenzkurve die Materialalterung nicht abbilden.

Aus der Druckschrift US 2011/0033985 A1 ist es bekannt, einen Shunt-Widerstand mit geringer Temperaturabhängigkeit des Widerstands auf einem integrierten Schaltung anzuordnen, wobei eine Kalibrierung des Shunt-Widerstands mit Komponenten der integrierten Schaltung erfolgen kann.

Aus der Schrift US 6,489,881 B1 ist ein Stromsensor bekannt, bei dem ein Widerstandschip verwendet wird, der in eine Vielzahl von seriellen und parallelen Widerstandssektoren unterteilt ist. Diese Sektoren sind in einer Richtung des Widerstandschips an seinen kürzeren Seiten durch gegenüberliegende erste und zweite Klemmen elektrisch anschließbar. Zusätzlich sind erste und zweite Sensierklemmen quer zur ersten Richtung vorgesehen, um den Stromfluss messen zu können.

Eine ähnliche Messvorrichtung ist aus der US 2003/0020592 A1 bekannt.

Offenbarung der Erfindung

Die vorliegende Erfindung offenbart einen Shunt-Widerstand, mit zwei Messanschlüssen zum Anlegen eines Messstroms, welcher entlang einer Hauptstromrichtung durch den Shunt-Widerstand fließt, Schlitzstrukturen, welche den Shunt-Widerstand entlang der Hauptstromrichtung in zwei Seitenstrombereiche mit jeweils einer ersten Breite und einen Hauptstrombereich mit einer zweiten Breite teilen, und zwei Kalibrieranschlüssen, welche quer zu der Hauptstromrichtung an den Seitenstrombereichen angeschlossen sind. Dieser Shunt-Widerstand bietet den Vorteil, dass die Seitenstrombereichen hochohmigere Kalibrierwiderstände aufweisen, welche insbesondere hochohmiger als der Shunt-Widerstand entlang der Hauptstromrichtung sind, durch die ein Kalibriersignal geringer Stromstärke geleitet werden kann, so dass die eigentliche Strommessung durch den Hauptstrombereich nicht beeinträchtigt wird. Zugleich weisen die Seitenstrombereiche ein nahezu identisches Verhalten bezüglich Temperaturabhängigkeit, Materialalterung und stromflussbedingter Widerstandsänderung auf, so dass von den in den Seitenstrombereichen gemessenen Charakteristika des Widerstands auf die Änderungen des Widerstands im Hauptstrombereich zurückgeschlossen werden kann. Diese Informationen können in vorteilhafter Weise dazu genutzt werden, die Strommessungen im Hauptstrombereich hinsichtlich Temperaturabhängigkeit, Materialalterung und stromflussbedingter Widerstandsänderung präzise und während des Betriebs des Shunt-Widerstands zu korrigieren.

Gemäß einer Ausführungsform schafft die vorliegende Erfindung daher ein System zum Erfassen eines Messstroms nach Anspruch 1, mit einem derartigen Shunt-Widerstand, einer Erfassungsschaltung, welche mit den Messanschlüssen des Shunt-Widerstands verbunden ist, und welche dazu ausgelegt ist, einen durch den Shunt-Widerstand fließenden Messstrom zu erfassen und in Abhängigkeit von dem erfassten Messstrom ein Messsignal zu erzeugen, einer Kalibriereinrichtung, welche mit den Kalibrieranschlüssen verbunden ist, und welche dazu ausgelegt ist, eine Referenzspannung oder einen Referenzstrom an die zwei Kalibrieranschlüsse anzulegen
und in Abhängigkeit von einer über den zwei Kalibrieranschlüssen abfallenden Spannung eine Kalibrierspannung zu ermitteln, und einer Korrekturschaltung, welche mit der Kalibriereinrichtung und der Erfassungsschaltung verbunden ist, und welche dazu ausgelegt ist, in Abhängigkeit von der erfassten Kalibrierspannung das von der Erfassungsschaltung erzeugte Messsignal zu korrigieren.

Eine Möglichkeit zur Ausgestaltung der Kalibriereinrichtung umfasst dabei eine Gleichstromquelle, welche an die Kalibrieranschlüsse des Shunt-Widerstands angeschlossen ist, und einen Operationsverstärker, welcher dazu ausgelegt ist, eine über die Kalibrieranschlüsse abfallende Gleichspannung zu erfassen und daraus die Kalibrierspannung zu erzeugen. Dies bietet den Vorteil, mit einem Gleichstrom geringer Stromstärke die Widerstandsänderungen in den Seitenstrombereichen des Shunt-Widerstands zu ermitteln, ohne des Messstrom zu verfälschen.

Diese Möglichkeit kann statt mit einer Gleichstromquelle mit einer Wechselstromquelle ausgestaltet werden. Diese hat - eine geeignete Frequenz für den eingeprägten Wechselstrom vorausgesetzt - den Vorteil, dass unabhängig von der Stärke des eingeprägten Stromes der Mittelwert des Stromes, der in den Seitenstrombereichen fließt, durch den zur Kalibrierung eingeprägten Strom nicht verändert wird. Dadurch erfolgt keine Änderung des Alterungsverhaltens in diesen Pfaden gegenüber dem Hauptstrombereich.

Eine Möglichkeit zur Ausgestaltung der Kalibriereinrichtung umfasst eine Wechselspannungsquelle, welche dazu ausgelegt ist, die Kalibrieranschlüsse mit einer Referenzwechselspannung zu beaufschlagen, zwei Kondensatoren, welche jeweils mit einem der zwei Kalibrieranschlüsse verbunden sind, zwei Widerstände, welche jeweils zwischen die zwei Kondensatoren und einen Masseanschluss gekoppelt sind, und einen Operationsverstärker, welcher dazu ausgelegt ist, eine Spannungsdifferenz zwischen den zwei Knotenpunkten zwischen den zwei Kondensatoren und den zwei Widerständen abzugreifen und daraus die Kalibrierspannung zu erzeugen. Die Kondensatoren können mit den Widerständen der Seitenstrombereiche des Shunt-Widerstands als Hochpass zusammenwirken, dessen Grenzfrequenz von den Widerstandswerten der Seitenstrombereiche des Shunt-Widerstands abhängt. Durch Ermittlung des Spannungstransfers durch den Hochpass bei bekannter eingeprägter Wechselspannung kann über die Änderung der Grenzfrequenz auf die Änderung der Widerstandswerte der Seitenstrombereiche des Shunt-Widerstands zurückgeschlossen werden.

Eine weitere Möglichkeit zur Ausgestaltung der Kalibriereinrichtung umfasst einen Ringoszillator, welcher mit den Kalibrieranschlüssen verbunden ist, und welcher dazu ausgelegt ist, eine Kalibrierspannung zu erzeugen, die eine Wechselspannung umfasst und deren Frequenz von dem Widerstand in den Seitenstrombereichen des Shunt-Widerstands abhängig ist. Die Oszillationsfrequenz des Ringoszillators hängt dabei von den Widerstandswerten der Seitenstrombereiche des Shunt-Widerstands ab. Über die Änderung der Oszillationsfrequenz des Ringoszillators kann wiederum auf die Änderung der Widerstandswerte der Seitenstrombereiche des Shunt-Widerstands zurückgeschlossen werden.

Gemäß einer Ausführungsform kann jeweils eine Referenzkalibriereinrichtung vorgesehen sein, die baugleiche bzw. identische Bauteile zur Kalibriereinrichtung aufweist. Die Referenzkalibriereinrichtung kann dabei mit einem Referenzshunt-Widerstand verbunden sein, der dem Shunt-Widerstand gleicht, aber nicht durch einen Messstrom durchflossen wird. Damit können vorteilhafterweise Einflüsse, welche nicht auf eine messstrombedingte Widerstandsänderung bzw. Materialalterung zurückzuführen sind, aus dem Vergleich des Kalibrierspannungen der Kalibriereinrichtung und der Referenzkalibriereinrichtung ermittelt werden.

Die Erfindung schafft gemäß einer weiteren Ausführungsform ein Verfahren zum Erfassen eines Messstroms, mit den Schritten des Erfassens eines durch einen derartigen Shunt-Widerstand fließenden Messstroms zum Erzeugen eines von dem erfassten Messstrom abhängigen Messsignals, des Anlegens einer Referenzspannung oder eines Referenzstroms an die Kalibrieranschlüsse des Shunt-Widerstands, des Erfassens einer über den zwei Kalibrieranschlüssen abfallenden Spannung, des Erzeugens einer Kalibrierspannung aus der über den zwei Kalibrieranschlüssen abfallenden Spannung, und des Korrigierens des Messsignals in Abhängigkeit von der Kalibrierspannung zum Ermitteln eines korrigierten Messstroms durch den Shunt-Widerstand.

Weitere Merkmale und Vorteile von Ausführungsformen der Erfindung ergeben sich aus der nachfolgenden Beschreibung mit Bezug auf die beigefügten Zeichnungen.

Kurze Beschreibung der Zeichnungen

Es zeigen:

Fig. 1a    eine schematische Darstellung eines Systems zum Erfassen eines Messstroms;

Fig. 1b    eine schematische Darstellung eines in dem System aus Fig. 1a verwendeten Shunt-Widerstands;

Fig. 2a    eine schematische Darstellung eines Systems zum Erfassen eines Messstroms gemäß einer Ausführungsform der Erfindung;

Fig. 2b    eine schematische Darstellung eines in dem System aus Fig. 2a verwendeten Shunt-Widerstands;

Fig. 3a    eine schematische Darstellung eines Systems zum Erfassen eines Messstroms gemäß einer weiteren Ausführungsform der Erfindung;

Fig. 3b    eine schematische Darstellung eines in dem System aus Fig. 3a verwendeten Shunt-Widerstands;

Fig. 4a    eine schematische Darstellung einer Korrekturschaltung gemäß einer weiteren Ausführungsform der Erfindung;

Fig. 4b    eine schematische Darstellung einer Korrekturschaltung gemäß einer weiteren Ausführungsform der Erfindung;

Fig. 5    eine schematische Darstellung eines Systems zum Erfassen eines Messstroms gemäß einer weiteren Ausführungsform der Erfindung;

Fig. 6 eine schematische Darstellung eines Systems zum Erfassen eines Messstroms gemäß einer weiteren Ausführungsform der Erfindung;

Fig. 7 eine schematische Darstellung einer Korrekturschaltung gemäß einer weiteren Ausführungsform der Erfindung;

Fig. 8 eine schematische Darstellung eines Systems zum Erfassen eines Messstroms gemäß einer weiteren Ausführungsform der Erfindung;

Fig. 9 eine schematische Darstellung eines Systems zum Erfassen eines Messstroms gemäß einer weiteren Ausführungsform der Erfindung;

Fig. 10a eine schematische Darstellung eines Systems zum Erfassen eines Messstroms;

Fig. 10b eine schematische Darstellung eines Systems zum Erfassen eines Messstroms;

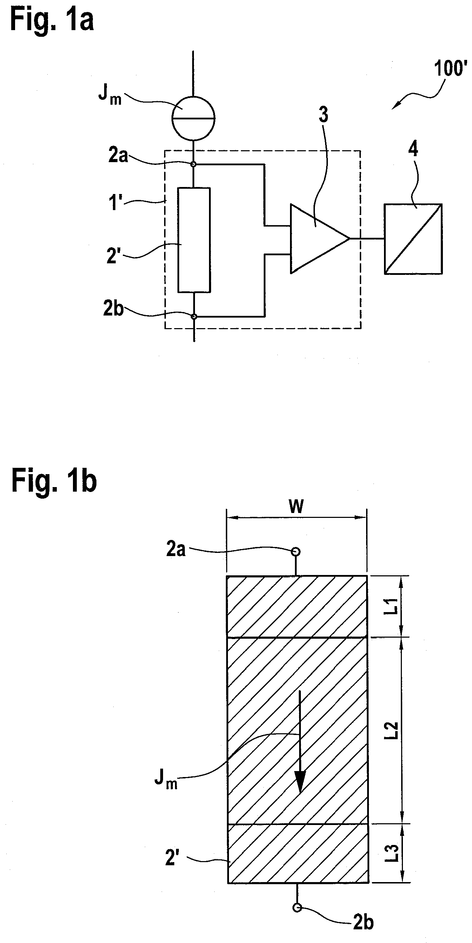

Fig. 1a zeigt eine schematische Darstellung eines Systems 100' zum Erfassen eines Messstroms $J_m$. Ein Shunt-Widerstand 2' weist zwei Messanschlüsse 2a und 2b an gegenüberliegenden Seiten des Shunt-Widerstands 2' auf. An diesen Messanschlüssen 2a und 2b kann eine Spannung abgegriffen werden, welche von dem Messstrom $J_m$ und den Widerstandswert des Shunt-Widerstands 2' abhängig ist. In einer Messschaltung 1' kann ein Operationsverstärker 3 angeordnet sein, der die über dem Shunt-Widerstand 2' abfallende Spannung erfasst und ein Messsignal ausgibt. Das Messsignal kann beispielsweise in einem Analog-Digital-Wandler (ADC) 4 in ein digitales Messsignal umgewandelt werden.

Fig. 1b zeigt eine schematische Darstellung eines in dem System 100' aus Fig. 1a verwendeten Shunt-Widerstands 2'. Der Shunt-Widerstand 2' wird von dem Strom $J_m$ entlang einer Hauptstromrichtung durchflossen. Entlang der Hauptstromrichtung weist der Shunt-Widerstand 2' eine Länge von L = L1 + L2 + L3 auf, wobei ein Mittelbereich mit der größten Länge L2 zwischen zwei Randbereichen L1 und L3 liegt. Der Shunt-Widerstand 2' weist die Breite W auf. Der Shunt-Widerstand 2' kann beispielsweise vollständig aus Metall gefertigt sein, und weist in allen Bereichen das gleiche Material auf.

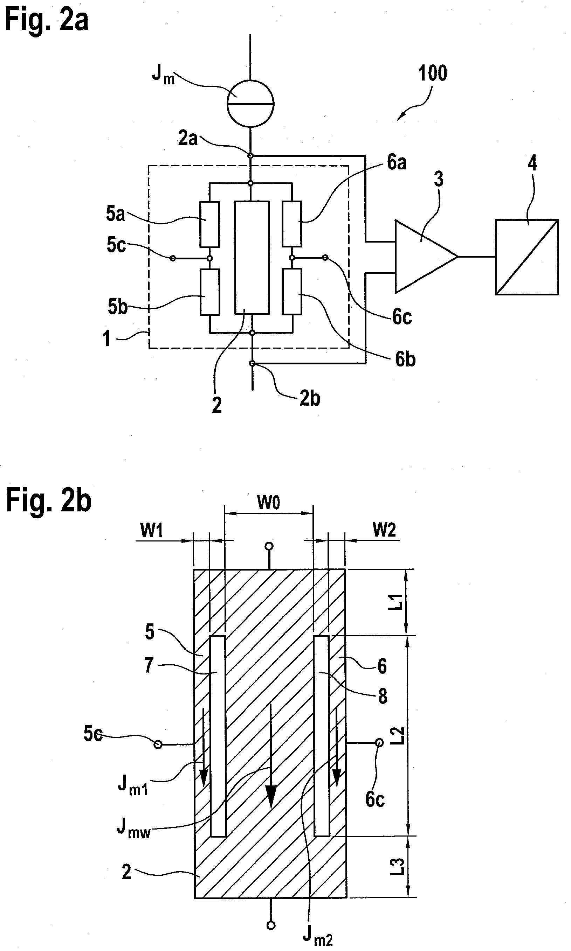

Fig. 2a zeigt eine schematische Darstellung eines Systems 100 zum Erfassen eines Messstroms $J_m$. Ein Shunt-Widerstand 2 weist zwei Messanschlüsse 2a und 2b an gegenüberliegenden Seiten des Shunt-Widerstands 2 auf. An diesen Messanschlüssen 2a und 2b kann eine Spannung abgegriffen werden, welche von dem Messstrom $J_m$ und den Widerstandswert des Shunt-Widerstands 2 abhängig ist. Ein Operationsverstärker 3 kann die über dem Shunt-Widerstand 2 abfallende Spannung erfassen und ein Messsignal ausgeben, welches beispielsweise in einem Analog-Digital-Wandler (ADC) 4 in ein digitales Messsignal umgewandelt werden kann.

Fig. 2b zeigt eine schematische Darstellung eines in dem System 100 aus Fig. 2a verwendeten Shunt-Widerstands 2. Der Shunt-Widerstand 2 unterscheidet sich von dem Shunt-Widerstand 2' in Fig. 1b im Wesentlichen dadurch, dass Schlitzstrukturen 7 und 8 in Längsrichtung in den Mittelbereich des Shunt-Widerstands 2 eingebracht sind. Dadurch wird der Mittelbereich in drei, über die Länge L2 quer zu der Hauptstromrichtung elektrisch voneinander getrennte Bereiche geteilt: zwei Seitenstrombereiche 5 und 6 sowie einen Hauptstrombereich. Der Hauptstrombereich kann beispielsweise die Breite W0 aufweisen, wohingegen die Seitenstrombereiche 5 und 6 jeweils die Breite W1 bzw. W2 aufweisen. Insbesondere können die Breiten W1 und W2 gleich groß sein und jeweils erheblich geringer als die Breite W0 des Hauptstrombereichs. Der Messstrom $J_m$, der durch den Shunt-Widerstand 2 entlang einer Hauptstromrichtung fließt, teilt sich dabei in drei Teilströme $J_{m1}$, $J_{mw}$, und $J_{m2}$ auf, wobei $J_m = J_{m1} + J_{mw} + J_{m2}$ gilt. An den zwei Seitenstrombereichen 5 und 6 sind jeweils Kalibrieranschlüsse 5c und 6c quer zu der Hauptstromrichtung angebracht. Die Kalibrieranschlüsse 5c und 6c sind jeweils auf halber Höhe L2/2 der Seitenstrombereiche 5 und 6 angeschlossen, so dass die Seitenstrombereiche 5 und 6 in zwei Strompfade aufgeteilt werden, welche, wie in Fig. 2a gezeigt, die Widerstände 5a und 5b bzw. 6a und 6b aufweisen.

Es kann selbstverständlich auch möglich sein, dass die Seitenstrombereiche 5 und 6 in einem Mittelbereich des Shunt-Widerstands 2 angeordnet sind, so dass der Hauptstrombereich zwei Hauptstrompfade aufweist, die am Rand der Shunt-Widerstands 2 entlang führen, während die zwei Strompfade der Seitenstrombereiche 5 und 6 in einem Mittelbereich des Shunt-Widerstands 2 entlang führen. Die Darstellung des Shunt-Widerstands 2 in Fig. 2b ist daher nur beispielhaft und kann je nach geometrischer Anordnung der Schlitzstrukturen auf viele verschiedene Arten ausgestaltet werden, solange der Shunt-Widerstand 2 in eine Anzahl Hauptstrompfade und zwei Strompfade mit einem höheren Widerstand als die Hauptstrompfade aufgeteilt werden.

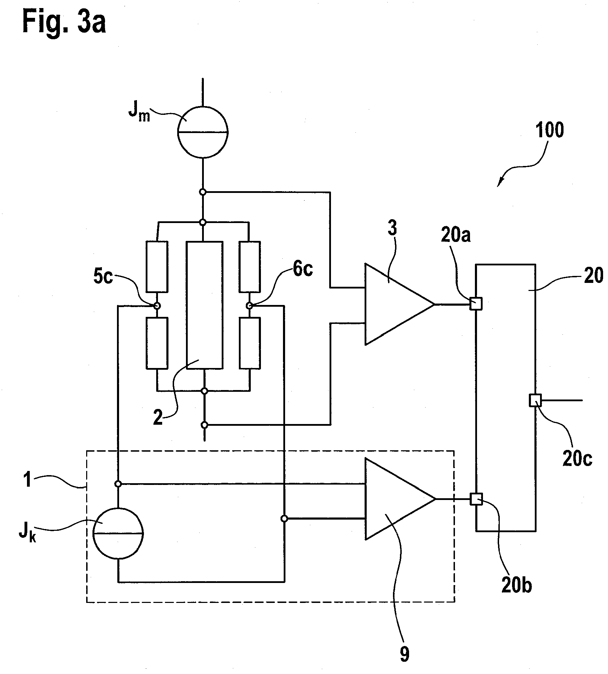

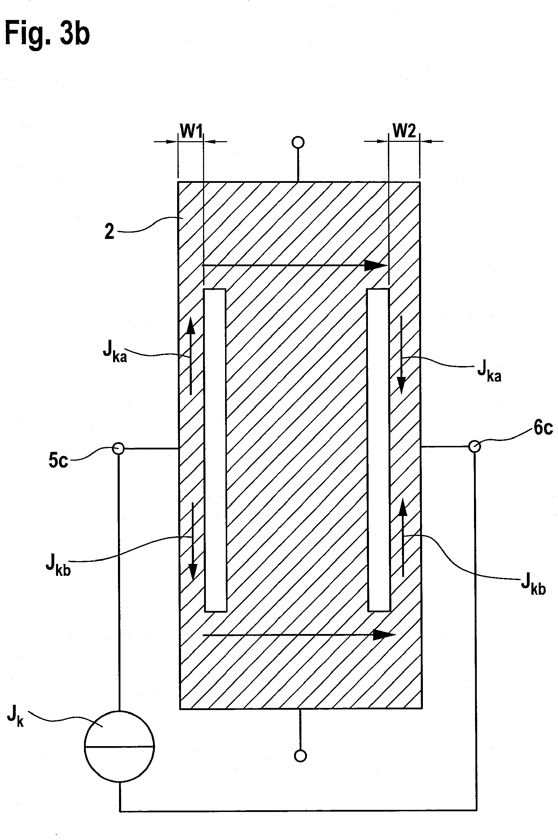

Fig. 3a zeigt eine schematische Darstellung eines Systems 100 zum Erfassen eines Messstroms $J_m$. Das System 100 unterscheidet sich von dem System 100 in Fig. 2a dahingehend, dass an den Kalibrieranschlüssen 5c und 6c eine Gleich- oder Wechselstromquelle $J_k$ angeschlossen ist, die einen Gleich- oder Wechselstrom durch den Shunt-Widerstand 2 schickt. In Fig. 3b ist die schematische Darstellung des Shunt-Widerstands 2 aus den Fig. 2a, 2b und 3a gezeigt. Der Strom $J_k$ von der Stromquelle $J_k$ tritt am Kalibrieranschluss 5c in den Shunt-Widerstand 2 ein und teilt sich auf die Widerstände 5a und 5b in Teilströme $J_{ka}$ und $J_{kb}$ auf. Die Kalibrieranschlüsse 5c und 6c sind jeweils auf halber Höhe des Hauptstrombereichs des Shunt-Widerstands 2 angeschlossen, so dass die Widerstände 5a und 5b bzw. 6a und 6b jeweils gleich groß sind. In diesem Fall sind auch die Teilströme $J_{ka}$ und $J_{kb}$ jeweils gleich groß und betragen jeweils die Hälfte des Stroms $J_k$. Die Teilströme $J_{ka}$

und $J_{kb}$ fließen in den Randbereichen des Shunt-Widerstands 2 jeweils quer zum Messstrom $J_m$. In den Randbereichen ist der Widerstand gegenüber den Widerständen 5a und 5b bzw. 6a und 6b jeweils vernachlässigbar, wenn die Länge L1 bzw. L2 der Randbereiche jeweils erheblich größer als die Breite W1 und W2 der Seitenstrombereiche gewählt wird. Die Teilströme $J_{ka}$ und $J_{kb}$ vereinigen sich am Kalibrieranschluss 6c wieder zu dem Strom $J_k$. Die Amplitude des Stroms $J_k$ kann aufgrund der geringen Breite der Seitenstrombereiche W1 und W2 gegenüber der wesentlich größeren Breite W0 des Hauptstrombereichs wesentlich kleiner gewählt werden als der Messstrom $J_m$, so dass der Messstrom nicht oder nur unwesentlich beeinflusst wird. Weiterhin wird die messbedingte Alterung des Shunt-Widerstands 2 durch die Einprägung des Stroms $J_k$ minimiert - insbesondere, wenn der Strom $J_k$ als Wechselstrom eingeprägt wird.

Das System 100 weist eine Kalibrierschaltung 1 auf, welche die Stromquelle $J_k$ und einen Operationsverstärker 9 umfasst. Der Operationsverstärker 9 ist dazu ausgelegt, die über die Kalibrieranschlüsse 5c und 6c abfallende Spannung zu erfassen. Diese erfasste Spannung hängt von den Widerstandswerten der Widerstände 5a, 5b, 6a und 6b ab, die ihrerseits einer Materialalterung unterliegen können. Der Operationsverstärker 9 erzeugt eine Kalibrierspannung, welche an einen Anschluss 20b einer Korrekturschaltung 20 übergeben werden kann. Gleichermaßen wird die Messspannung des Operationsverstärkers 3 an einen Anschluss 20a der Korrekturschaltung 20 übergeben, welche die Messspannung auf die Kalibrierspannung korrigiert, so dass an einem Ausgang 20c der Korrekturschaltung eine korrigierte bzw. kalibrierte Messspannung zur Verfügung gestellt wird.

Der Hauptstrombereich und die Seitenstrombereiche 5, 6 des Shunt-Widerstands 2 unterliegen den gleichen alterungs- und/oder temperaturbedingten Veränderungen, so dass mit der Kalibrierspannung diese Einflüsse auf den Shunt-Widerstand 2 in der Korrekturschaltung 20 eliminiert werden können und somit die Erfassung des Messstroms $J_m$ über die gesamte Betriebsdauer des Shunt-Widerstands 2 präzise erfolgen kann. Die Kalibrierung des Messstroms $J_m$ kann beispielsweise kontinuierlich oder in zyklisch geeigneten Abständen erfolgen. Es kann vorteilhaft sein, die Stromrichtung der Gleichstromquelle in geeigneten zeitlichen Abständen umzupolen, das heißt, ein rechteckförmiges Stromsignal einzuprägen, damit die Stromdichte in den beiden Seitenstrombereichen im Mittel genauso groß ist, wie die Stromdichte im Hauptstrombereiche, so dass die stromdichtebedingte Alterung konstant bleibt. Weiterhin kann es hierzu vorteilhaft sein, statt einer Gleichstromquelle eine Wechselstromquelle einzusetzen. Es kann alternativ auch möglich sein, den Strom $J_k$ nur für kurze Zeit in den Shunt-Widerstand 2 einzuprägen, beispielsweise in gepulster Form. Dadurch kann der zusätzliche Stromeintrag in den Shunt-Widerstand 2 verringert werden und die messbedingten Veränderungen der Widerstandswerte minimiert werden.

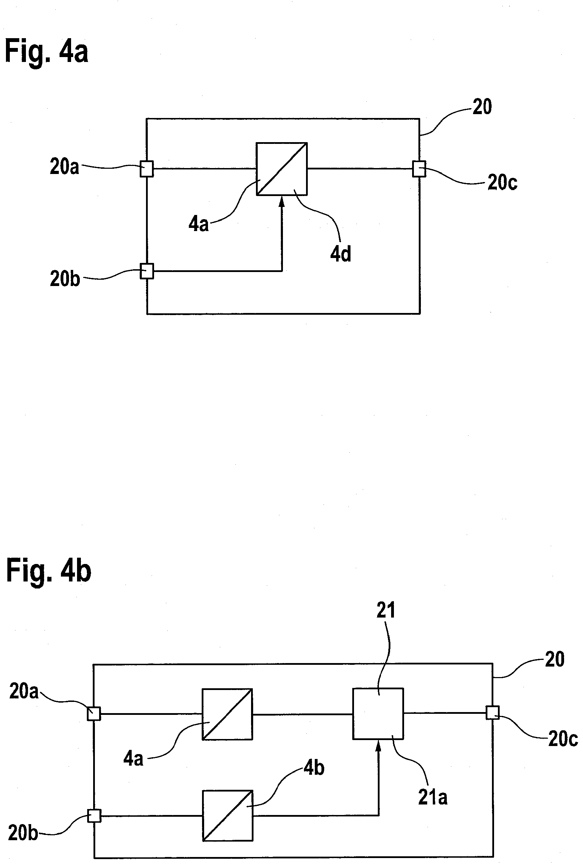

In den Fig. 4a und 4b sind schematische Darstellung für mögliche Ausführungsformen der Korrekturschaltung 20 in Fig. 3a gezeigt. Die Korrekturschaltung 20 in Fig. 4a weist einen ADC 4a auf, welcher einen Referenzspannungseingang 4d umfasst. Der ADC 4a wandelt die Messspannung des Operationsverstärkers 3 von analoger in digitale Form um, wobei die Kalibrierspannung des Operationsverstärkers 9 als Referenzspannung an den Referenzspannungseingang 4d des ADCs 4a angelegt wird. Die Korrekturschaltung 20 in Fig. 4a weist zwei ADCs 4a und 4b sowie ein digitales Rechenwerk auf. Die Spannungssignale der Operationsverstärker 3 und 9 werde in den ADCs 4a bzw. 4b digitalisiert. Das digitale Rechenwerk 21 weist einen Referenzanschluss 21 auf, an welchen das digitalisierte Kalibrierspannungssignal des Operationsverstärkers 9 angelegt wird, um das digitale Messspannungssignal des Operationsverstärkers 3 rechnerisch zu korrigieren.

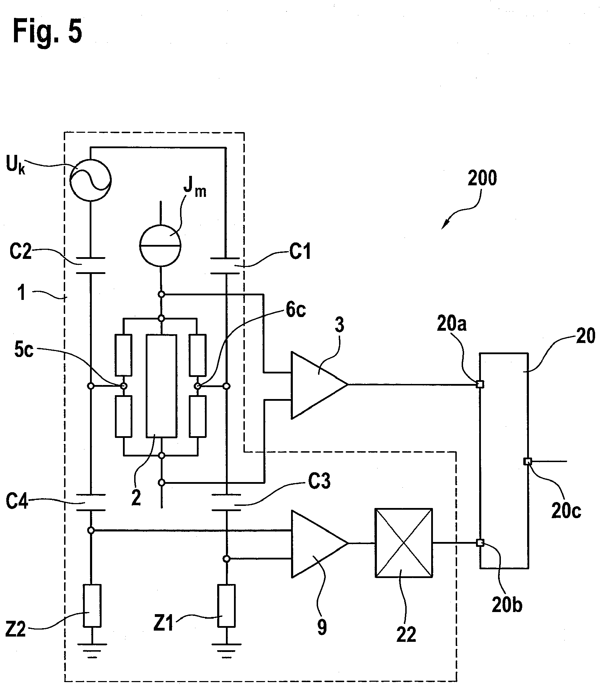

Es versteht sich für einen Fachmann, dass eine der in den Fig. 4a und 4b gezeigten Korrekturschaltungen 20 jeweils auch für eine der im Folgenden beschriebenen Korrekturschaltungen 20 der Fig. 5, 8, 9, 10a und 10b eingesetzt werden kann.

Es kann vorgesehen sein, eine Referenzkalibriereinrichtung zu der Kalibriereinrichtung 1 in Fig. 3a auszugestalten. Dazu kann ein Referenzshunt-Widerstand, der dem Shunt-Widerstand 2 baugleich ist, über die Kalibrieranschlüsse mit einer Referenzgleichstromquelle verbunden werden. Eine über die Kalibrieranschlüsse des Referenzshunt-Widerstands abfallende Referenzspannung kann dann mithilfe eines Referenzoperationsverstärkers erfasst werden. Die Referenzkalibriereinrichtung unterscheidet sich von der Kalibriereinrichtung dadurch, dass der Referenzshunt-Widerstand im Gegensatz zu dem Shunt-Widerstand 2 nicht von dem Messstrom $J_m$ durchflossen wird. Dadurch kann durch Vergleich der von der Referenzkalibriereinrichtung erzeugten Referenzkalibrierspannung und der von der Kalibriereinrichtung erzeugten Kalibrierspannung auf die durch den Messstrom $J_m$ verursachte stromdichtebedingte Alterung des Shunt-Widerstands 2 zurückgeschlossen werden, da alle anderen externen Einflüsse wie Temperaturabhängigkeit oder sonstige Einflüsse sowohl in der Referenzkalibriereinrichtung als auch in der Kalibriereinrichtung gleichermaßen auftreten.

Fig. 5 zeigt eine schematische Darstellung eines Systems 200 zum Erfassen eines Messstroms. Das System 200 unterscheidet sich von dem System 100 in Fig. 2a und 3a im Wesentlichen dadurch, dass eine andere Kalibriereinrichtung 1 eingesetzt wird. Eine Wechselspannungsquelle $U_k$ ist dazu ausgelegt, über Kondensatoren C1 und C2 jeweils einen der zwei Kalibrieranschlüsse 5c und 6c mit einer Wechselspannung zu beaufschlagen, so dass die Widerstände 5a und 5b bzw. 6a und 6b mit jeweils einem der Kondensatoren C1 bzw. C2 ein erstes Hochpassglied für die Hochpassfilterung der Wechselspannung $U_k$ an die Anschlüsse 5c bzw. 6c darstellen. Die Kalibrieranschlüsse 5c und 6c sind jeweils mit Kondensatoren C3 und C4 verbunden. Beispielsweise können die Kondensatoren C3 und C4 jeweils die gleiche Kapazität C aufweisen, und die Kondensatoren C1 und C2 können jeweils die gleiche Kapazität $C_k$ aufweisen. Dabei hängt die Amplitude der an den Kondensatoren C3 und C4 anliegenden Wechselspannung jeweils von der Grenzfrequenz $f_g$ der ersten Hochpassglieder ab, die ihrerseits wiederum von den Widerstandswerten $R_k$ der Widerstände 5a und 5b bzw. 6a und 6b abhängen:

$$f_g = (2\pi R_k C_k)^{-1}$$

Unter Zuhilfenahme zweier Impedanzen Z1 und Z2, welche zwischen die Kondensatoren C3 und C4 sowie ein Referenzpotential, beispielsweise ein Massepotential, gekoppelt werden, kann zwischen den Knoten zwischen den Kondensatoren C3 bzw. C4 und den Impedanzen Z1 bzw. Z2 eine Referenzspannung abgegriffen werden, welche von dem Operationsverstärker 9 erfasst wird, um eine Kalibrierspannung zu erzeugen.

Die Kondensatoren C3 und C4 bilden somit mit den Impedanzen Z1 bzw. Z2 jeweils ein zweites Hochpassglied. Dabei kann die Grenzfrequenz der zweiten Hochpassglieder vorzugsweise identisch gewählt und so gelegt werden, dass sie niedriger liegt als die Grenzfrequenz $f_g$ der ersten Hochpassglieder. Dadurch kann erreicht werden, dass die zwischen den Anschlüssen 5c und 6c anliegende Kalibrierspannung betraglich kaum gedämpft wird, sondern lediglich das Eingangspotential auf den Operationsverstärker 9 optimiert.

Die Kalibrierspannung hängt von der Grenzfrequenz $f_g$ ab. Wenn beispielsweise die Grenzfrequenz $f_g$ so gewählt wird, dass die Frequenz der Wechselspannung $U_k$ größer oder gleich der Grenzfrequenz $f_g$ ist, dann führt jede Widerstandserhöhung der Widerstände 5a, 5b, 6a und 6b dazu, dass die Kalibrierspannung größer wird. Damit kann die Kalibrierspannung des Operationsverstärkers 9 in einem Mischer 22 gemischt werden und in die Korrekturschaltung 20 eingespeist werden, um die Messspannung des Operationsverstärkers 3 zu korrigieren.

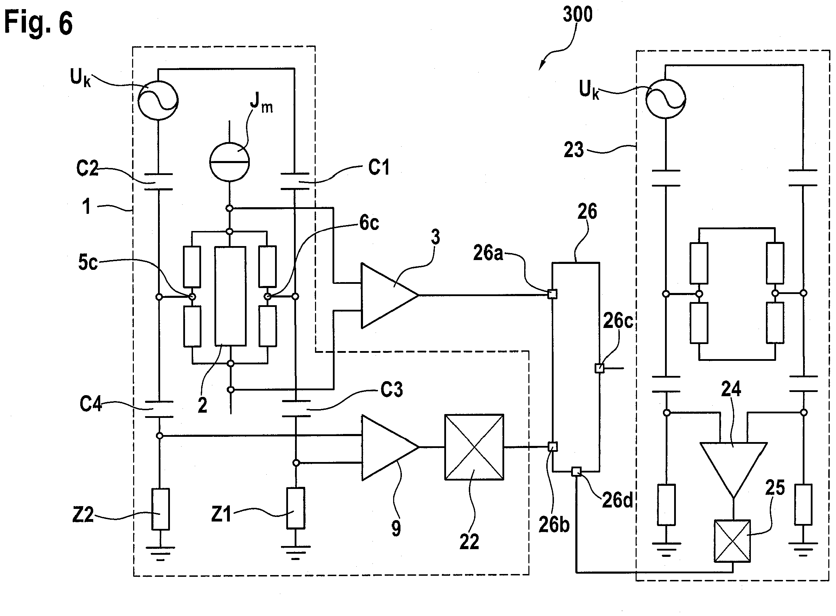

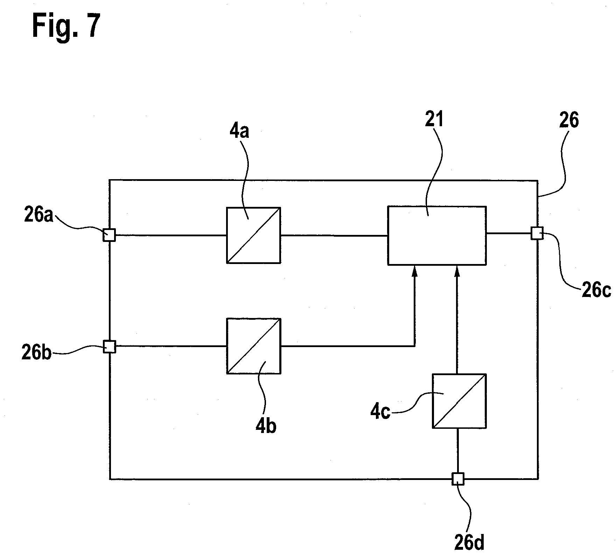

Fig. 6 zeigt eine schematische Darstellung eines Systems 300 zum Erfassen eines Messstroms $J_m$. Das System 300 unterscheidet sich von dem System 300 in Fig. 5 im Wesentlichen dadurch, dass eine Referenzkalibriereinrichtung vorgesehen 23, welche im Wesentlichen die gleichen Komponenten aufweist wie die Kalibriereinrichtung 1. Dabei ist jedoch der in der Referenzkalibriereinrichtung 23 angeordnete Referenzshunt-Widerstand nicht von einem Messstrom $J_m$ durchflossen. Die durch den Referenzoperationsverstärker 24 erzeugte Referenzkalibrierspannung wird in einem Referenzmischer 25 gemischt und an einen Referenzanschluss 26d einer Korrekturschaltung 26 übergeben. Die Korrekturschaltung 26 ist in Fig. 7 in größerem Detail gezeigt. Die Korrekturschaltung 26 unterscheidet sich von der Korrekturschaltung 20 in Fig. 4b im Wesentlichen dadurch, dass ein dritter ADC 4c vorgesehen ist, in dem die Referenzkalibrierspannung des Referenzanschlusses 26d digitalisiert wird. Zusätzlich zu der in dem ADC 4b digitalisierten Kalibrierspannung der Kalibriereinrichtung wird dann die digitalisierte Referenzkalibrierspannung in das digitale Rechenwerk 21 eingespeist, um das digitalisierte Messsignal des ADC 4a noch präziser korrigieren zu können.

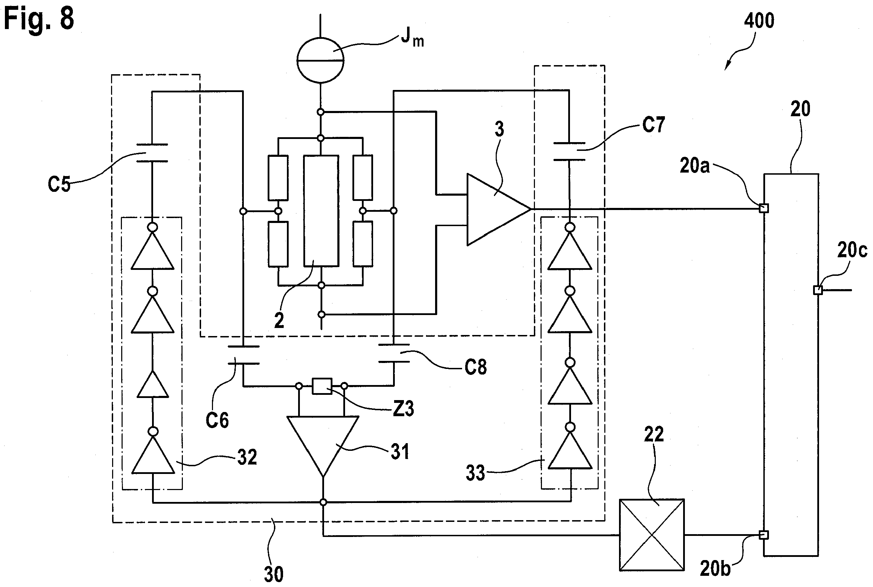

Fig. 8 zeigt eine schematische Darstellung eines Systems 400 zum Erfassen eines Messstroms $J_m$. Das System 400 unterscheidet sich von den Systemen 100 in Fig. 2a und 3a und 200 in Fig. 5 im Wesentlichen dadurch, dass eine andere Kalibriereinrichtung 1 eingesetzt wird. Die Kalibriereinrichtung 1 weist eine Ringoszillatorschaltung 30 auf, welche mit den Kalibrieranschlüssen 5c und 6c des Shunt-Widerstands 2 verbunden ist. Die Ringoszillatorschaltung 30 kann aus zwei Schleifen aufgebaut sein, welche jeweils mit verschiedenen der Kalibrieranschlüsse 5c und 6c verbunden sind. Eine erste Schleife weist eine erste Verstärkerkette 32 mit einem Verstärker und einer ungradzahligen Anzahl - z.B. drei - Invertern auf, welche in Reihe mit einem Kondensator C5 gekoppelt sind. Ein weiterer Kondensator C6 ist zwischen einen der Kalibrieranschlüsse 5c und einen Eingang eines Operationsverstärkers 31 gekoppelt. Eine zweite Schleife weist eine zweite Verstärkerkette 33 mit einer geradzahligen Anzahl -z.B. vier - Invertern auf, welche in Reihe mit einem Kondensator C7 gekoppelt sind. Ein weiterer Kondensator C8 ist zwischen den anderen der Kalibrieranschlüsse 6c und den anderen Eingang eines Operationsverstärkers 31 gekoppelt. Beide Schleifen sind über die Eingänge des Operationsverstärkers 31 hinweg über eine Impedanz Z3 gekoppelt. Die Oszillationsfrequenz des Ringoszillators 30 hängt dabei unter Anderem von den Widerstandswerten der Widerstände 5a, 5b, 6a und 6b ab, so dass eine Spannung, welche an dem Ausgang des Operationsverstärkers 31 anliegt, eine Wechselspannungsfrequenz aufweist, welche sich mit den Widerstandswerten der Widerstände 5a, 5b, 6a und 6b ändert. Die Ausgangsspannung des Ringoszillators 30 kann daher in einem Mischer 22 gemischt werden und als Kalibrierspannung an den Anschluss 20b einer Korrekturschaltung 20 übergeben werden.

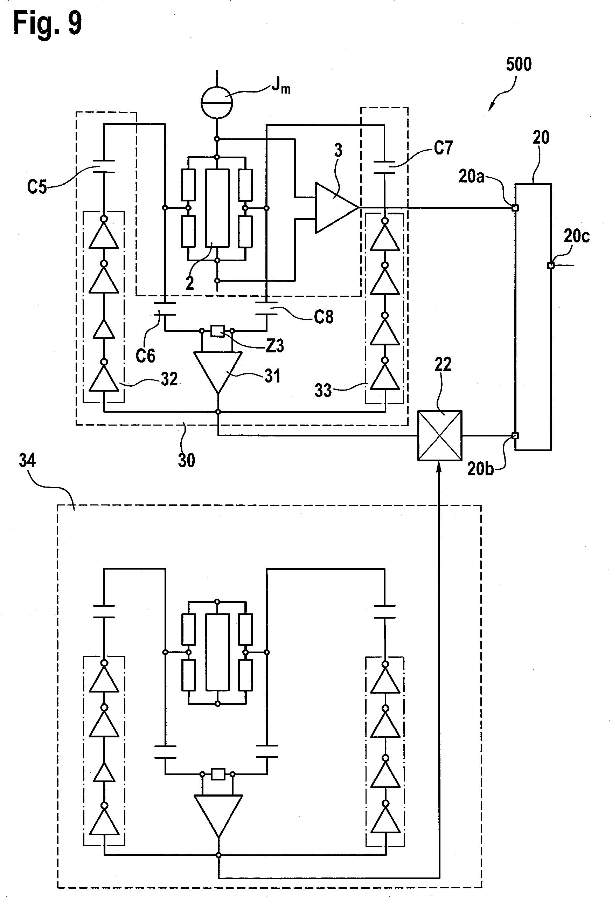

Fig. 9 zeigt eine schematische Darstellung eines Systems 500 zum Erfassen eines Messstroms $J_m$. Das System 500 unterscheidet sich von dem System 400 in Fig. 8 dadurch, dass ein Referenzringoszillator 34 vorgesehen ist, der eine Referenzkalibrierspannung erzeugt, die in dem Mischer 22 mit der Kalibrierspannung des Ringoszillators 30 gemischt werden kann.

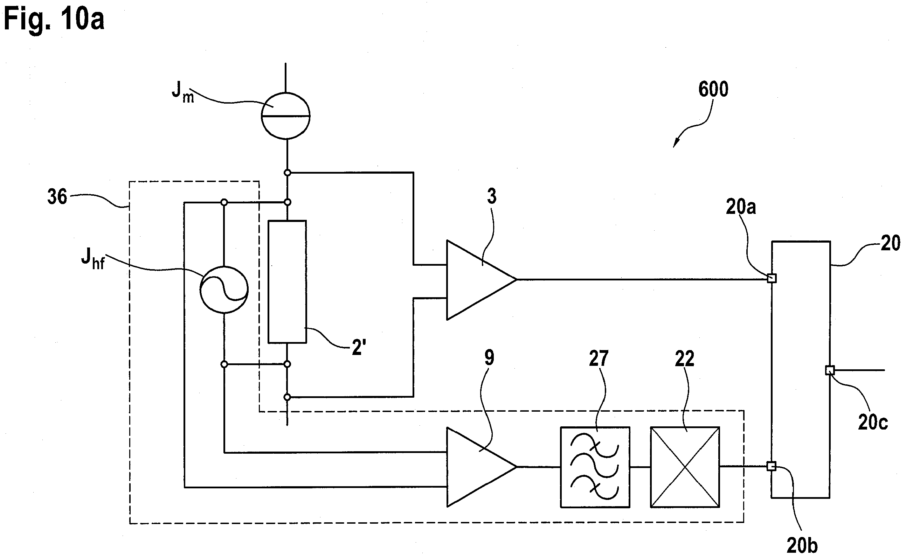

Figur 10a zeigt eine schematische Darstellung eines nicht erfindungsgemäßen Systems 600 zum Erfassen eines Messstroms $J_m$. Das System 600 umfasst einen Shunt-Widerstand 2', der den Aufbau des Shunt-Widerstands 2' in Fig. 1 b aufweisen kann. Über Messanschlüsse 2a und 2b wird ein Messstrom $J_m$ in den Shunt-Widerstand 2' eingespeist und über einen Operationsverstärker 3 wird die über den Shunt-Widerstand 2' durch den Messstrom $J_m$ verursachte Spannung erfasst. Zusätzlich zu dem Messstrom $J_m$ wird über eine Wechselstromquelle $J_{hf}$ in einer Kalibriereinrichtung 36 ein Wechselstrom hoher Frequenz in den Shunt-Widerstand 2' über die Messanschlüsse 2a und 2b eingeprägt. Der Wechselstrom $J_{hf}$ kann im Vergleich zu dem Messstrom $J_m$ eine wesentlich höhere Frequenz und eine wesentlich geringere Amplitude aufweisen. Über einen Operationsverstärker 9 wird ebenfalls die über die Messanschlüsse 2a und 2b abfallende Spannung des Shunt-Widerstands 2' ermittelt. Die von dem Operationsverstärker 9 ausgegebene Messspannung wird in einen Bandpassfilter 27 eingespeist, welcher eine Bandpassfrequenz aufweist, die auf die Frequenz des Wechselstrom $J_{hf}$ abgestimmt ist. Der Bandpassfilter 27 weist dabei vorzugsweise eine sehr geringe Bandbreite und/oder eine sehr hohe Filtergüte auf. Je geringer die Bandbreite des Bandpassfilters 27 ist, desto geringer kann die Amplitude des Wechselstroms $J_{hf}$ gewählt werden. Die von dem Bandpassfilter 27 gefilterte Ausgangsspannung des Operationsverstärkers 9 gibt damit den von dem Wechselstrom $J_{hf}$ verursachten Spannungsanteil der über dem Shunt-Widerstand 2' abfallenden Gesamtspannung wieder. Die Veränderungen in diesem Spannungsanteil können dann wiederum zum Kalibrieren der durch den Operationsverstärker 3 ermittelten Messspannung in einer Korrekturschaltung 20 herangezogen werden.

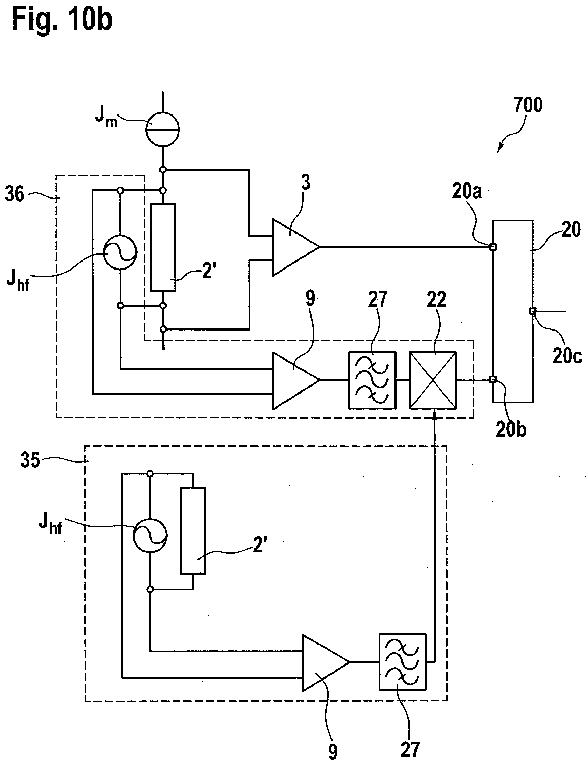

Fig. 10b zeigt eine schematische Darstellung eines Systems 700 zum Erfassen eines Messstroms $J_m$. Das System 700 unterscheidet sich von dem System 600 in Fig. 10a dadurch, dass eine Referenzkalibriereinrichtung 35 vorgesehen ist, die eine Referenzkalibrierspannung erzeugt, die in dem Mischer 22 mit der Kalibrierspannung der Kalibriereinrichtung 36 gemischt werden kann.

**Patentansprüche**

1.  System (100; 200; 300; 400; 500) zum Erfassen eines Messstroms ($J_m$), mit:

    - einem Shunt-Widerstand (2), wobei der Shunt-Widerstand (2)

    • zwei Messanschlüssen (2a; 2b) zum Anlegen eines Messstroms ($J_m$), wobei der Messstrom entlang einer Hauptstromrichtung durch den Shunt-Widerstand (2) fließt;
    • Schlitzstrukturen (7; 8), welche den Shunt-Widerstand (2) entlang der Hauptstromrichtung in zwei Seitenstrombereiche (5; 6) mit jeweils einer ersten Breite (W1; W2) und einen Hauptstrombereich mit einer zweiten Breite (W0) teilen, wobei die Seitenstrombereiche (5;6) und der Hauptstrombereich aus dem gleichen Material hergestellt sind; und
    • zwei Kalibrieranschlüssen (5c; 6c), welche quer zu der Hauptstromrichtung an den Seitenstrombereichen (5; 6) angeschlossen sind, wobei die Kalibrieranschlüsse (5c, 6c) jeweils auf halber Höhe der Seitenstrombereiche (5, 6) angeschlossen sind, aufweist, und

    - einer Erfassungsschaltung (3), welche mit den Messanschlüssen (2a; 2b) des Shunt-Widerstands (2) verbunden ist, und welche dazu ausgelegt ist, einen durch den Shunt-Widerstand (2) fließenden Messstrom ($J_m$) zu erfassen und in Abhängigkeit von dem erfassten Messstrom ($J_m$) ein Messsignal zu erzeugen; **dadurch gekennzeichnet, dass**

    die zweite Breite (W0) des Shunt-Widerstands (2) grösser ist als die erste Breite (W1; W2); und dass das System weiterhin umfasst

    - eine Kalibriereinrichtung (1), welche mit den Kalibrieranschlüssen (5c; 6c) verbunden ist, und welche dazu ausgelegt ist eine Referenzspannung oder einen Referenzstrom an die zwei Kalibrieranschlüsse (5c; 6c) anzulegen und in Abhängigkeit von einer über den zwei Kalibrieranschlüssen (5c; 6c) abfallenden Spannung eine Kalibrierspannung zu ermitteln; und

    - eine Korrekturschaltung (20; 26), welche mit der Kalibriereinrichtung (1) und der Erfassungsschaltung (3) verbunden ist, und welche dazu ausgelegt ist, in Abhängigkeit von der erfassten Kalibrierspannung das von der Erfassungsschaltung (3) erzeugte Messsignal zu korrigieren.

2.  System (100) nach Anspruch 1, **dadurch gekennzeichnet, dass** die Kalibriereinrichtung (1) umfasst:

    - eine Gleich- oder Wechselstromquelle ($J_k$), welche an die Kalibrieranschlüsse (5c; 6c) des Shunt-Widerstands (2) angeschlossen ist; und
    - einen Operationsverstärker (9), welcher dazu ausgelegt ist, eine über die Kalibrieranschlüsse (5c; 6c) abfallende Gleich- oder Wechselspannung zu erfassen und daraus die Kalibrierspannung zu erzeugen.

3.  System (100) nach Anspruch 2, **dadurch gekennzeichnet, dass**

    - ein Referenzshunt-Widerstand, welcher dem Shunt-Widerstand (2) baugleich ausgebildet ist, und welcher nicht durch einen Messstrom ($J_m$) durchflossen wird; und
    - eine Referenzkalibriereinrichtung mit einer Referenzstromquelle, welche an die Kalibrieranschlüsse (5c; 6c) des Referenzshunt-Widerstands angeschlossen ist; und

- ein Referenzoperationsverstärker, welcher dazu ausgelegt ist, eine über die Kalibrieranschlüsse (5c; 6c) des Referenzshunt-Widerstands abfallende Spannung zu erfassen und daraus eine Referenzkalibrierspannung zu erzeugen,

vorgesehen ist,
wobei die Korrekturschaltung (26) mit der Referenzkalibriereinrichtung verbunden ist und dazu ausgelegt ist, die erfasste Kalibrierspannung auf die Referenzkalibrierspannung zu normieren.

4. System (200; 300) nach Anspruch 1, **dadurch gekennzeichnet, dass** die Kalibriereinrichtung (1) umfasst:

- eine Wechselspannungsquelle ($U_k$), welche dazu ausgelegt ist, die Kalibrieranschlüsse (5c; 6c) mit einer Referenzwechselspannung zu beaufschlagen; und
- zwei Kondensatoren (C3; C4), welche jeweils mit einem der zwei Kalibrieranschlüsse (5c; 6c) verbunden sind; und
- zwei Widerstände (Z1; Z2), welche jeweils zwischen die zwei Kondensatoren (C3; C4) und einen Masseanschluss gekoppelt sind; und
- einen Operationsverstärker (9), welcher dazu ausgelegt ist, eine Spannungsdifferenz zwischen zwei Knotenpunkten zwischen den zwei Kondensatoren (C3; C4) und den zwei Widerständen (Z1; Z2) abzugreifen und daraus die Kalibrierspannung zu erzeugen.

5. System (300) nach Anspruch 4, **dadurch gekennzeichnet, dass**

- ein Referenzshunt-Widerstand, welcher dem Shunt-Widerstand (2) baugleich ausgebildet ist, und welcher nicht durch den Messstrom ($J_m$) durchflossen wird; und
- eine Referenzkalibriereinrichtung (23) mit einer Referenzwechselspannungsquelle, welche an die Kalibrieranschlüsse (5c; 6c) des Referenzshunt-Widerstands angeschlossen ist, und
- zwei Referenzkondensatoren, welche jeweils mit einem der zwei Kalibrieranschlüsse (5c; 6c) des Referenzshunt-Widerstands verbunden sind, und
- zwei Referenzwiderständen, welche jeweils zwischen die zwei Referenzkondensatoren und einen Masseanschluss gekoppelt sind; und
- ein Referenzoperationsverstärker (24), welcher dazu ausgelegt ist, eine Spannungsdifferenz zwischen den zwei Knotenpunkten zwischen den zwei Referenzkondensatoren und den zwei Referenzwiderständen abzugreifen und daraus eine Referenzkalibrierspannung zu erzeugen,

vorgesehen ist,
wobei die Korrekturschaltung (26) mit der Referenzkalibriereinrichtung (23) verbunden ist und dazu ausgelegt ist, die erfasste Kalibrierspannung auf die Referenzkalibrierspannung zu normieren,

6. System (400; 500) nach Anspruch 1, **dadurch gekennzeichnet, dass** die Kalibriereinrichtung (1) umfasst:

einen Ringoszillator (30), welcher mit den Kalibrieranschlüssen (5c; 6c) verbunden ist, und welcher dazu ausgelegt ist, eine Kalibrierspannung zu erzeugen, die eine Wechselspannung umfasst und deren Frequenz von dem Widerstand in den Seitenstrombereichen (5; 6) des Shunt-Widerstands (2) abhängig ist.

7. Verfahren zum Erfassen eines Messstroms ($J_m$), mit den Schritten:

- Erfassen eines durch einen Shunt-Widerstand (2) fließenden Messstroms ($J_m$) zum Erzeugen eines von dem erfassten Messstrom ($J_m$) abhängigen Messsignals,
wobei der Shunt-Widerstand

• zwei Messanschlüssen (2a; 2b) zum Anlegen eines Messstroms ($J_m$), wobei der Messstrom entlang einer Hauptstromrichtung durch den Shunt-Widerstand (2) fließt;
• Schlitzstrukturen (7; 8), welche den Shunt-Widerstand (2) entlang der Hauptstromrichtung in zwei Seitenstrombereiche (5; 6) mit jeweils einer ersten Breite (W1; W2) und einen Hauptstrombereich mit einer zweiten Breite (WO) teilen; und
• zwei Kalibrieranschlüsse (5c; 6c), welche quer zu der Hauptstromrichtung an den Seitenstrombereichen (5; 6) angeschlossen sind, wobei die Kalibrieranschlüsse (5c, 6c) jeweils auf halber Höhe der Seitenstrombereiche (5, 6) angeschlossen sind,
• wobei die zweite Breite (WO) des Shunt-Widerstands (2) grösser ist als die erste Breite(W1;W2), und wobei die Seitenstrombereiche (5;6) und der Hauptstrombereich aus dem gleichen Material hergestellt sind,

aufweist, und
- Anlegen einer Referenzspannung oder eines Referenzstroms an die Kalibrieranschlüsse (5c; 6c) des Shunt-Widerstands (2); und

- Erfassen einer über den zwei Kalibrieranschlüssen (5c; 6c) abfallenden Spannung; und
- Erzeugen einer Kalibrierspannung aus der über den zwei Kalibrieranschlüssen (5c; 6c) abfallenden Spannung; und
- Korrigieren des Messsignals in Abhängigkeit von der Kalibrierspannung zum Ermitteln eines korrigierten Messstroms ($J_m$) durch den Shunt-Widerstand (2).

**Claims**

1. System (100; 200; 300; 400; 500) for detecting a measurement current ($J_m$), having:

    - a shunt resistor (2), wherein the shunt resistor (2) has

        • two measurement terminals (2a; 2b) for applying a measurement current ($J_m$), wherein the measurement current flows through the shunt resistor (2) along a main current direction;
        • slot structures (7; 8), which divide the shunt resistor (2) along the main current direction into two side current regions (5; 6) each having a first width (W1; W2) and a main current region having a second width (W0), wherein the side current regions (5; 6) and the main current region are made of the same material; and
        • two calibration terminals (5c; 6c), which are connected to the side current regions (5; 6) transversely to the main current direction, wherein the calibration terminals (5c, 6c) are each connected halfway up the side current regions (5, 6),

    and
    - a detection circuit (3), which is connected to the measurement terminals (2a; 2b) of the shunt resistor (2) and which is configured to detect a measurement current ($J_m$) flowing through the shunt resistor (2) and to generate a measurement signal depending on the detected measurement current ($J_m$);

    **characterized in that**
    the second width (W0) of the shunt resistor (2) is larger than the first width (W1; W2); and **in that** the system further comprises

    - a calibration device (1), which is connected to the calibration terminals (5c; 6c) and which is configured to apply a reference voltage or a reference current to the two calibration terminals (5c; 6c) and to determine a calibration voltage depending on a voltage dropped across the two calibration terminals (5c; 6c); and
    - a correction circuit (20; 26), which is connected to the calibration device (1) and the detection circuit (3) and which is configured to correct the measurement signal generated by the detection circuit (3) depending on the detected calibration voltage.

2. System (100) according to Claim 1, **characterized in that** the calibration device (1) comprises:

    - a DC or AC source ($J_k$), which is connected to the calibration terminals (5c; 6c) of the shunt resistor (2); and
    - an operational amplifier (9), which is configured to detect a DC or AC voltage dropped across the calibration terminals (5c; 6c) and to generate the calibration voltage therefrom.

3. System (100) according to Claim 2, **characterized in that** the following are provided:

    - a reference shunt resistor, which is structurally identical to the shunt resistor (2) and through which a measurement current ($J_m$) does not flow; and
    - a reference calibration device having a reference current source, which is connected to the calibration terminals (5c; 6c) of the reference shunt resistor; and
    - a reference operational amplifier, which is configured to detect a voltage dropped across the calibration terminals (5c; 6c) of the reference shunt resistor and to generate a reference calibration voltage therefrom,

    wherein the correction circuit (26) is connected to the reference calibration device and is configured to normalize the detected calibration voltage to the reference calibration voltage.

4. System (200; 300) according to Claim 1, **characterized in that** the calibration device (1) comprises:

    - an AC voltage source ($U_k$), which is configured to supply a reference AC voltage to the calibration terminals (5c; 6c); and
    - two capacitors (C3; C4), which are each connected to one of the two calibration terminals (5c; 6c); and
    - two resistors (Z1; Z2), which are each coupled between the two capacitors (C3; C4) and a ground connection; and
    - an operational amplifier (9), which is configured to tap a voltage difference between two nodes between the two capacitors (C3; C4) and the two resistors (Z1; Z2) and to generate the calibration voltage therefrom.

5. System (300) according to Claim 4, **characterized in that** the following are provided:

- a reference shunt resistor, which is structurally identical to the shunt resistor (2) and through which the measurement current ($J_m$) does not flow; and
- a reference calibration device (23) having a reference AC voltage source, which is connected to the calibration terminals (5c; 6c) of the reference shunt resistor; and
- two reference capacitors, which are each connected to one of the two calibration terminals (5c; 6c) of the reference shunt resistor, and
- two reference resistors, which are each coupled between the two reference capacitors and a ground connection; and
- a reference operational amplifier (24), which is configured to tap a voltage difference between the two nodes between the two reference capacitors and the two reference resistors and to generate a reference calibration voltage therefrom,

wherein the correction circuit (26) is connected to the reference calibration device (23) and is configured to normalize the detected calibration voltage to the reference calibration voltage.

6. System (400; 500) according to Claim 1, **characterized in that** the calibration device (1) comprises:

a ring oscillator (30), which is connected to the calibration terminals (5c; 6c) and which is configured to generate a calibration voltage, said calibration voltage comprising an AC voltage and having a frequency which is dependent on the resistance in the side current regions (5; 6) of the shunt resistor (2).

7. Method for detecting a measurement current ($J_m$), having the following steps:

- detecting a measurement current ($J_m$) flowing through a shunt resistor (2) in order to generate a measurement signal dependent on the detected measurement current ($J_m$),
wherein the shunt resistor has

• two measurement terminals (2a; 2b) for applying a measurement current ($J_m$), wherein the measurement current flows through the shunt resistor (2) along a main current direction;
• slot structures (7; 8), which divide the shunt resistor (2) along the main current direction into two side current regions (5; 6) each having a first width (W1; W2) and a main current region having a second width (W0); and
• two calibration terminals (5c; 6c), which are connected to the side current regions (5; 6) transversely to the main current direction, wherein the calibration terminals (5c, 6c) are each connected halfway up the side current regions (5, 6),
• wherein the second width (W0) of the shunt resistor (2) is larger than the first width (W1; W2), and wherein the side current regions (5; 6) and the main current region are made of the same material,

and

- applying a reference voltage or a reference current to the calibration terminals (5c; 6c) of the shunt resistor (2); and
- detecting a voltage dropped across the two calibration terminals (5c; 6c); and
- generating a calibration voltage from the voltage dropped across the two calibration terminals (5c; 6c); and
- correcting the measurement signal depending on the calibration voltage in order to determine a corrected measurement current ($J_m$) through the shunt resistor (2).

## Revendications

1. Système (100 ; 200 ; 300 ; 400 ; 500) destiné à la détection d'un courant de mesure ($J_m$), avec :

- une résistance de shunt (2), où la résistance de shunt (2) présente :

• deux bornes de mesure (2a ; 2b) en vue de l'application d'un courant de mesure ($J_m$), où le courant de mesure est acheminé le long d'une direction principale du courant à travers la résistance de shunt (2) ;
• des structures à fentes (7 ; 8), lesquelles scindent la résistance de shunt (2) en deux régions latérales de courant (5 ; 6) le long de la direction principale du courant, avec respectivement une première largeur (W1 ; W2), d'une part, et une région principale du courant avec une deuxième largeur (W0), d'autre part, où les régions latérales de courant (5 ; 6) et la région principale du courant sont fabriquées à partir du même matériau ; et
• deux bornes de calibrage (5c ; 6c), lesquelles sont connectées perpendiculairement à la direction principale du courant au niveau des régions latérales de courant (5 ;

6), où les bornes de calibrage (5c ;

6c) sont connectées respectivement à la mi-hauteur des régions latérales de courant (5 ; 6) ; et

- un circuit de détection (3), lequel est raccordé aux bornes de mesure (2a ; 2b) de la résistance de shunt (2) et lequel est conçu en ce sens qu'il est destiné à détecter un courant de mesure ($J_m$) étant acheminé par l'intermédiaire de la résistance de shunt (2) et à produire un signal de mesure en fonction du courant de mesure ($J_m$) détecté ;

**caractérisé en ce que**
la deuxième largeur (W0) de la résistance de shunt (2) est plus grande que la première largeur (W1 ; W2) ; et **caractérisé en ce que** le système comprend en outre :

- un mécanisme de calibrage (1), lequel est raccordé aux bornes de calibrage (5c ; 6c) et lequel est conçu en ce sens qu'il est destiné à permettre l'application d'une tension de référence ou d'un courant de référence au niveau des deux bornes de calibrage (5c ; 6c) et à déterminer une tension de calibrage en fonction d'une baisse de tension sur les deux bornes de calibrage (5c ; 6c) ; et

- un circuit de correction (20 ; 26), lequel est raccordé au mécanisme de calibrage (1) et au circuit de détection (3) et lequel est conçu en ce sens qu'il est destiné à corriger le signal de mesure généré en fonction de la tension de calibrage détecté par le circuit de détection (3).

2. Système (100) selon la revendication 1, **caractérisé en ce que** le mécanisme de calibrage (1) comprend :

- une source de courant continu ou une source de courant alternatif ($J_k$), laquelle est connectée aux bornes de calibrage (5c ; 6c) de la résistance de shunt (2) ; et

- un amplificateur opérationnel (9), lequel est conçu en ce sens qu'il est destiné à détecter une baisse de la tension continue ou de la tension alternative par l'intermédiaire des bornes de calibrage (5c ; 6c) et à produire la tension de calibrage en conséquence.

3. Système (100) selon la revendication 2, **caractérisé en ce que** sont prévus :

- une résistance de shunt de référence, laquelle présente une conception identique à la résistance de shunt (2) et laquelle n'est pas traversée par un courant de mesure ($J_m$) ; et

- un mécanisme de calibrage de référence avec une source de courant de référence, lequel est connecté aux bornes de calibrage (5c ; 6c) de la résistance de shunt de référence ; et

- un amplificateur opérationnel de référence, lequel est conçu en ce sens qu'il est destiné à détecter une baisse de tension par l'intermédiaire des bornes de calibrage (5c ; 6c) de la résistance de shunt de référence et à produire une tension de calibrage de référence en conséquence,

dans lequel le circuit de correction (26) est raccordé au mécanisme de calibrage de référence et est conçu en ce sens qu'il est destiné à normaliser la tension de calibrage détectée par rapport à la tension de calibrage de référence.

4. Système (200 ; 300) selon la revendication 1, **caractérisé en ce que** le mécanisme de calibrage (1) comprend :

- une source de tension alternative ($U_k$), laquelle est conçue en ce sens qu'elle est destinée à permettre l'application d'une tension alternative de référence sur les bornes de calibrage (5c ; 6c) ; et

- deux condensateurs (C3 ; C4), lesquels sont raccordés respectivement à l'une des deux bornes de calibrage (5c ; 6c) ; et

- deux résistances (Z1 ; Z2), lesquelles sont couplées respectivement entre les deux condensateurs (C3 ; C4) et une borne de masse ; et

- un amplificateur opérationnel (9), lequel est conçu en ce sens qu'il est destiné à permettre la déduction d'une différence de tension entre les deux jonctions se trouvant entre les deux condensateurs (C3 ; C4) et les deux résistances (Z1 ; Z2) et à produire la tension de calibrage en conséquence.

5. Système (300) selon la revendication 4, **caractérisé en ce que** sont prévus :

- une résistance de shunt de référence, laquelle présente une conception identique à la résistance de shunt (2) et laquelle n'est pas traversée par le courant de mesure ($J_m$) ; et

- un mécanisme de calibrage de référence (23) avec une source de tension alternative de référence, laquelle est connectée au niveau des bornes de calibrage (5c ; 6c) de la résistance de shunt de référence ; et

- deux condensateurs de référence, lesquels sont raccordés respectivement à l'une des deux bornes de calibrage (5c ; 6c) de la résistance de shunt de référence ; et

- deux résistances de référence, lesquelles sont couplées respectivement entre les deux condensateurs de référence et une borne de masse ; et

- un amplificateur opérationnel de référence (24), lequel est conçu en ce sens qu'il est destiné à permettre la déduction d'une différence de tension entre les deux jonctions se trouvant entre les deux condensateurs de référence et les deux résistances de référence et à produire une tension de calibrage de référence en conséquence,

dans lequel le circuit de correction (26) est raccordé au mécanisme de calibrage de référence (23) et est conçu en ce sens qu'il est destiné à normaliser la tension de calibrage détectée par rapport à la tension de calibrage de référence.

6. Système (400 ; 500) selon la revendication 1, **caractérisé en ce que** le mécanisme de calibrage (1) comprend :

un oscillateur en anneau (30), lequel est raccordé aux bornes de calibrage (5c ; 6c), et lequel est conçu en ce sens qu'il est destiné à produire une tension de calibrage qui comprend une tension alternative et dont la fréquence dépend de la résistance qui existe dans les régions latérales de courant (5 ; 6) de la résistance de shunt (2).

7. Procédé destiné à la détection d'un courant de mesure ($J_m$), comprenant les phases suivantes :

- la détection d'un courant de mesure ($J_m$) circulant à travers une résistance de shunt (2) en vue de la production d'un signal de mesure qui dépend du courant de mesure ($J_m$) détecté,

dans lequel la résistance de shunt présente :

• deux bornes de mesure (2a ; 2b) en vue de l'application d'un courant de mesure ($J_m$), où le courant de mesure est acheminé le long d'une direction principale du courant par l'intermédiaire de la résistance de shunt (2) ;
• des structures à fentes (7 ; 8), lesquelles scindent la résistance de shunt (2) en deux régions latérales de courant (5 ; 6) le long de la direction principale du courant avec respectivement une première largeur (W1 ; W2), d'une part, et une région principale du courant avec une deuxième largeur (W0), d'autre part ; et
• deux bornes de calibrage (5c ; 6c), lesquelles sont connectées perpendiculairement à la direction principale du courant au niveau des régions latérales de courant (5 ; 6), où les bornes de calibrage (5c, 6c) sont connectées respectivement à la mi-hauteur des régions latérales de courant (5, 6) ;
• dans lequel la deuxième largeur (W0) de la résistance de shunt (2) est plus grande que la première largeur (W1 ; W2) et dans lequel les régions latérales de courant (5 ; 6) et la région principale du courant sont fabriquées à partir du même matériau ;

et

- l'application d'une tension de référence ou d'un courant de référence au niveau des bornes de calibrage (5c ; 6c) de la résistance de shunt (2) ; et
- la détection d'une baisse de tension sur les deux bornes de calibrage (5c ; 6c) ; et
- la production d'une tension de calibrage à partir de la baisse de tension sur les deux bornes de calibrage (5c ; 6c) ; et
- la correction du signal de mesure en fonction de la tension de calibrage en vue de la détermination d'un courant de mesure ($J_m$) corrigé par l'intermédiaire de la résistance de shunt (2).

# Fig. 1a

# Fig. 1b

## Fig. 2a

## Fig. 2b

# Fig. 3a

# Fig. 3b

## Fig. 4a

## Fig. 4b

# Fig. 5

Fig. 6

# Fig. 7

Fig. 8

EP 2 726 885 B1

**Fig. 9**

# Fig. 10a

EP 2 726 885 B1

# Fig. 10b

**EP 2 726 885 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110033985 A1
- US 6489881 B1
- US 20030020592 A1